# EUROPEAN PATENT APPLICATION

(11) **EP 4 556 379 A1**
(43) Date of publication of application: **21.05.2025**
(21) Application number: 24212973.2
(22) Date of filing: 14.11.2024
(51) Int. Cl.: B64G 1/54

(54) **SELF-SUPPORTING SPACE ENVIRONMENT PROTECTION DEVICE FOR SPACE APPLICATIONS AND METHOD OF MANUFACTURING THE DEVICE**

(30) Priority: 20.11.2023 US 202363601018 P
(71) Applicant: MacDonald, Dettwiler and Associates Corporation, Ste-Anne-de-Bellevue, QC H9X 3R2 (CA)
(72) Inventor: Ross, Alpha Dixon Steven, Sainte-Anne-de-Bellevue, Quebec, H9X 3R2 (CA); Desrosiers, Étienne, Sainte-Anne-de-Bellevue, Quebec, H9X 3R2 (CA); MacInnis, Glenn, Sainte-Anne-de-Bellevue, Quebec, H9X 3R2 (CA); Sénéchal, Gérard, Sainte-Anne-de-Bellevue, Quebec, H9X 3R2 (CA); Chartrand, Francis, Sainte-Anne-de-Bellevue, Quebec, H9X 3R2 (CA)
(74) Representative: Grünecker Patent- und Rechtsanwälte PartG mbB

(57) **Abstract**

A self-supporting space environment protection device and method of manufacturing the device are provided. The device includes a self-supporting polymer-based body (104) manufactured for installation on a component (102) of a space-based system and composed of a space radiation resistant polymer-based material. The device further includes a low-absorptivity finish applied to an external surface (114) of the self-supporting polymer-based body (104), the low-absorptivity finish having a solar absorptivity (α) value lower than the space radiation resistant polymer-based material, and a low-emissivity finish applied to the internal surface (116) of the self-supporting polymer-based body (104), the low-emissivity finish having an infrared emissivity (ε) value lower than the space radiation resistant polymer-based material.

## Description

### Technical Field

The following relates generally to space environment protection devices, and more particularly to space environment protection devices for space-based applications and satellite systems.

### Introduction

Space environment protection is needed for structures, components, or mechanisms in space-based applications when exposed to harsh environments and environmental threats such as radiation and atomic oxygen exposures, micrometeoroid and orbital debris (MMOD) collision, and significant temperature ranges and/or extremes.

Existing approaches to protecting such structures, components, or mechanisms includes thermal blankets. Traditional thermal blankets are flexible and need a support structure, with multiple attachment points between the blanket and the support structure. The thermal blankets are typically made using pattern developed by a seamstress, where the pattern is created using the flight antenna, and subsequently the thermal blanket is fabricated, and finally installed. Before fabrication, the pattern-maker of the thermal blanket is required to wait until the completion of the final assembly of the structures, components, or mechanisms. This requirement adds complexity to determining the exact shape of the thermal blanket before installation, leading up to multiple iteration and adjustment of the thermal blanket's configuration. This process is costly, time consuming and a schedule driver.

Thermal blankets are typically made of flexible polymer-based materials that are very low in thermal conductivity reducing the transfer of thermal energy to the protected structures, components, or mechanisms. Due to the thermal blanket's nature and variable configuration, effective thermal properties are largely inconsistent as they are highly dependent on the attachments used, number of slits/discontinuities and number of folds. These factors collectively lead to lower the insulation efficiency of thermal blankets.

The thermal blankets are fragile and vulnerable to tear and may potentially jam or interfere with the proper operation of the structure, component, or mechanism being covered. Any damage to the thermal blanket may not be easily detectable and could potentially lead to mission failure. Any repair may be difficult, or even impossible if already in space. Therefore, large stay outs and clearances are typically required when installing on structures, components, or mechanisms which ultimately leads to important installation challenges and reduction in insulation efficiencies.

Other existing approaches to protecting structures, components, or mechanisms in space, can be cost inefficient and heavy, such as a thermally insulated metallic sheet (e.g., aluminum sheet with insulating washer).

With the increasing expansion of space operations, particularly in the realm of satellite constellations, there arises a pressing demand for high-volume production of structures, components, or mechanisms to support the industry. Consequently, an imperative lies in the development of cost/schedule efficient solution to safeguard such structures, components, or mechanisms from rigors of space.

Accordingly, a pressing need exists for an improved space environment protection device for structures, components, or mechanisms in space applications that overcome at least some of the disadvantages of existing systems and methods.

### Summary

A self-supporting space environment protection device for covering a component of a space-based system is provided. The device comprises a self-supporting polymer-based body manufactured for installation on the component and composed of a space radiation resistant polymer-based material, the self-supporting polymer-based body comprising an internal surface that faces the component when the self-supporting space environment protection device is installed and an external surface exposed to the space environment.

In an embodiment, a low-absorptivity finish is applied to the external surface of the self-supporting polymer-based body, the low-absorptivity finish having a solar absorptivity (α) value lower than the space radiation resistant polymer-based material.

In an embodiment, a low-emissivity finish is applied to the internal surface of the self-supporting polymer-based body, the low-emissivity finish having an infrared emissivity (ε) value lower than the space radiation resistant polymer-based material.

In an embodiment, the space radiation resistant polymer-based material is either one of polymer composite, polyetherketoneketone (PEKK), PEKK-based FDM thermoplastic, or polyetherimide (PEl).

In an embodiment, the space radiation resistant polymer is carbon loaded to provide electrical conductivity and reduce ESD risk related to use of the self-supporting space environment protection device.

In an embodiment, the low-absorptivity finish is a white paint.

In an embodiment, the low-emissivity finish is a metallic plating.

In an embodiment, the metallic plating includes multiple plating layers, the multiple plating layers including a silver plating layer on a nickel plating layer or a gold plating layer on a nickel plating layer.

In an embodiment, the metallic plating includes multiple plating layers including a final metallic plating layer that is a nickel plating, a gold plating, or a silver plating.

In an embodiment, the low emissivity finish is a low-emissivity paint.

In an embodiment, the device is configured to cover a partial section of the component used in space.

In an embodiment, the rigid polymer-based body is manufactured using either one of an additive manufacturing, a molding process, or a subtraction machining process.

In an embodiment, a low-absorptivity finish is applied to the external surface of the self-supporting polymer-based body and a low-emissivity finish applied to the internal surface of the self-supporting polymer-based body, the low-absorptivity finish having a solar absorptivity (α) value lower than the space radiation resistant polymer-based material and the low-emissivity finish having an infrared emissivity (ε) value lower than the space radiation resistant polymer-based material.

A method of manufacturing a self-supporting space environment protection device for covering a component used in space is provided. The method comprises recording a physical profile of the space component; fabricating a self-supporting polymer-based body based on the recorded physical profile of the temperature-sensitive device from a space radiation resistant polymer; applying a low-absorptivity finish on an external surface of the self-supporting polymer-based body, the low-absorptivity finish having a solar absorptivity (α) value lower than the space radiation resistant polymer-based material; and applying a low-emissivity finish on an internal surface of the self-supporting polymer-based body, the low-emissivity finish having an infrared emissivity (ε) value lower than the space radiation resistant polymer-based material.

In an embodiment, the fabricating of the rigid polymer body is performed using either one of an additive manufacturing, a molding process, or a subtraction machining process.

In an embodiment, the self-supporting polymer-based body is fabricated to cover a partial section of the component used in space.

In an embodiment, the low-absorptivity finish is a white paint.

In an embodiment, the low-emissivity finish is a metallic plating. The metallic plating may include multiple plating layers. The multiple plating layers may include a silver plating layer on a nickel plating layer. The multiple plating layers may include gold plating layer on a nickel plating layer.

In an embodiment, the metallic plating includes multiple plating layers including a final metallic plating layer that is a nickel plating, a gold plating, or a silver plating.

In an embodiment, the low emissivity finish is a low-emissivity paint.

Other aspects and features will become apparent, to those ordinarily skilled in the art, upon review of the following description of some exemplary embodiments.

### Brief Description of the Drawings

The drawings included herewith are for illustrating various examples of articles, methods, and apparatuses of the present specification. In the drawings:
Figure 1 is a schematic cross section view of a self-supporting space environment protection device for covering and providing space environment protection to a structure, component, or mechanism, according to an embodiment;
Figure 2 is a schematic cross section view of a self-supporting space environment protection device comprising two of said devices of Figure 1 stacked together, according to an embodiment; and
Figure 3 is a flow diagram of a method of manufacturing the self-supporting space environment protection device of Figure 1, according to an embodiment.

### Detailed Description

Various apparatuses or processes will be described below to provide an example of each claimed embodiment. No embodiment described below limits any claimed embodiment and any claimed embodiment may cover processes or apparatuses that differ from those described below. The claimed embodiments are not limited to apparatuses or processes having all of the features of any one apparatus or process described below or to features common to multiple or all of the apparatuses described below.

Further, although process steps, method steps, algorithms or the like may be described (in the disclosure and / or in the claims) in a sequential order, such processes, methods and algorithms may be configured to work in alternate orders. In other words, any sequence or order of steps that may be described does not necessarily indicate a requirement that the steps be performed in that order. The steps of processes described herein may be performed in any order that is practical. Further, some steps may be performed simultaneously.

When a single device or article is described herein, it will be readily apparent that more than one device / article (whether or not they cooperate) may be used in place of a single device / article. Similarly, where more than one device or article is described herein (whether or not they cooperate), it will be readily apparent that a single device / article may be used in place of the more than one device or article.

The following relates generally to space environment protection devices, and more particularly to self-supporting space environment protection devices for space-based applications and satellite systems.

Generally, the present disclosure provides a self-supporting space environment protection device that may be applied to a particular component of a space-based system (i.e., a system designed to be used in space). The type, function, and structural characteristics of the component being covered (wholly or partially) may vary and is not particularly limited. For example, the component may be any mechanism, structure, or other infrastructure of the space-based system that requires or may benefit from protection provided by the self-supporting space environment protection device. Accordingly, it is to be understood that reference throughout the present to a "component" that is being protected or covered by the space-based environment protection device may include a mechanism, structure, or other infrastructure of the space-based system as described above.

The disclosed space environment protection device includes a self-supporting body, defining a cavity within which a component used in space is contained (wholly or partially) when the device is installed on said component. The shape of the self-supporting body may be configured to entirely enclose a shape or geometrical profile of the component. In some cases, the shape of the self-supporting body may be configured to match or substantially follow or mimic the profile of the component so that the space occupied by the self-supporting space environment protection device covering the component is reduced or minimized while also providing sufficient clearance for the component being covered. In an embodiment, the self-supporting space environment protection device is additively manufactured from a additively manufacturable space qualified polymer-based material that is resistant to space radiation and, in some cases, has ESD dissipative properties (e.g., carbon filled or loaded). In various applications, the external and internal surfaces of the self-supporting body may be bare or have a finish applied thereto. An external space-facing surface of the self-supporting body may have a low absorptivity finish applied thereto. An internal component -facing surface of the self-supporting body may have a low emissivity finish applied thereto, such as a metal plating or low emissivity paint.

In an embodiment, the present disclosure provides a space environment protection device for covering (wholly or partially) a component. The device includes a self-supporting polymer-based body manufactured for installation on the component and composed of a space radiation resistant polymer-based material. The self-supporting polymer-based body includes an internal surface that faces the component when installed and an external surface exposed to the space environment. The device includes a low absorptivity finish applied to the external surface that has a solar absorptivity value lower than the polymer-based material. The device further includes a low-emissivity finish applied to the internal surface of the self-supporting polymer-based body that has an infrared emissivity value lower than the polymer-based material.

In an embodiment, the space radiation resistant polymer is carbon loaded to provide electrical conductivity and reduce ESD risk related to use of the device. The self-supporting polymer-based body is manufactured using a an additive manufacturing technique.

It should be noted that while the present disclosure often focuses on embodiments of the device used for thermal protection in space environments, the device of the present disclosure may be configured and used for protection from other space environmental factors, such as described herein, and such embodiments are contemplated by and form part of the present disclosure.

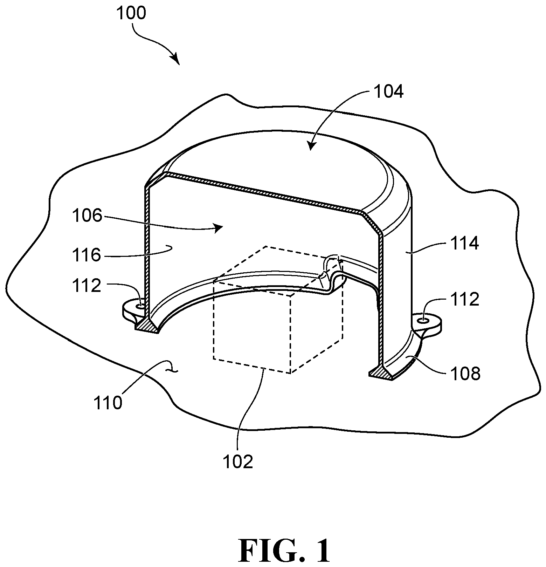

Referring now to Figure 1, shown therein is a schematic diagram of a self-supporting space environment protection device 100, according to an embodiment.

The self-supporting space environment protection device 100 may be used to replace a complex shaped blanket in providing thermal protection to a component 102 for use in space applications.

In an embodiment, component 102 is a mechanism. The term mechanism includes any temperature sensitive structure, or instrument intended for use in outer space. The mechanism may include a motor, antenna, electrical components, hold-and-release mechanisms, or other space-use structures. The component 102 of Figure 1 may be an actuator of the antenna, such as a rotary actuator. The rotary actuator may facilitate movement of a boom for manipulating the antenna (e.g., a reflector of the antenna). The component 102 may be a motor for performing sensitive pointing of hardware.

The self-supporting space environment protection device 100 covers, not limited to, a temperature-sensitive component 102 of an electromechanical system used in space applications. In variations, the device 100 may be used to cover a component that is to be used in space, and may cover the component wholly or only partially (e.g., a particular part of component). The component 102 requires thermal protection in order to properly function and/or meet mission performance objectives. The self-supporting space environment protection device 100 thus helps provide a relatively thermally benign operating environment for the component 102. The self-supporting space environment protection device 100 maintains the component 102 within a more benign temperature range than the component 102 would see if not protected. The component 102 in Figure 1 is represented as a generic cylindrical prism in hashed lines for illustrative purposes. In variations, the component 102 may have various shapes and sizes. In an embodiment, the rigid self-supporting polymer-based device 100 is designed or installed to cover a section or an entire surface of the component.

In an example, the electromechanical system may be an antenna. The antenna may be a steerable antenna.

The self-supporting space environment protection device 100 includes a self-supporting body 104. The self-supporting body 104 defines a cavity 106 within which the component 102 is contained when the self-supporting space environment protection device 100 is applied to the component 102. The self-supporting body 104 may have any shape that can be achieved with the material from which the self-supporting body 104 is created. The shape of the self-supporting body 104 may be configured to entirely enclose a shape or geometrical profile of the component 102. In some cases, the shape of the self-supporting body 104 may be configured to match or substantially follow or mimic the profile of the component 102 so that the space occupied by the self-supporting space environment protection device 100 covering the component 102 is reduced or minimized while also providing sufficient clearance for the component 102 being covered. The device 100 may be efficiently placed over complex-shaped components for thermal protection.

The self-supporting body 104 includes a bottom edge piece 108. The bottom edge piece 108 may have a flat bottom surface. The bottom edge piece 108 is used to position the self-supporting space environment protection device 100 on a surface 110 of a space vehicle platform on which the component 102 is mounted or disposed. In other embodiments, the bottom edge piece 108 may not be present. For example, the body 104 may be bonded in a groove.

The self-supporting space environment protection device 100 includes mounting holes 112 for installing the self-supporting space environment protection device 100. The mounting holes 112 are used to receive fasteners (e.g., screws) therethrough for mounting or securing the thermal device to the platform 110 or component 102. The mounting holes 112 may be threaded or unthreaded. While the self-supporting space environment protection device 100 of Figure 1 uses mounting holes 112 and fasteners for mounting, in other embodiments, any other suitable form of securing the self-supporting space environment protection device 100 to the platform surface 110 or component 102 may be used.

The self-supporting body 104 is composed of a self-supporting polymer-based material. The polymer may be an additively manufacturable polymer. Using an additively manufacturable polymer may allow for greater variation in the shapes the self-supporting body 104 can take (for example, using a shape profile of the component or clearance dimensions). In various embodiments, the self-supporting space environment protection device 100 may be manufactured using an additive manufacturing process, a molding process (such as a machine mold or injection mold), or a subtraction machining process.

The polymer-based material is a space compatible material. The polymer is space radiation resistant. The polymer is an ESD dissipative material.

The polymer may be polyetherketoneketone (PEKK) or a PEKK based material. PEKK is a semi-crystalline, high-performance thermoplastic resin known for its strength, high temperature tolerance, and excellent chemical resistance properties. In an embodiment, the PEKK based materiel is additively manufactured PEKK-based FDM (Fused Deposition Modeling) thermoplastic. The polymer may be polyetherimide or an polyetherimide-based material. The polymer may be thermoplastic or a thermoplastic-based material. The polymer may be any suitable additively manufacturable space qualified polymer providing radiation resistance and ESD dissipative properties (e.g., bleeds off electrical charges).

In an embodiment, the polymer may be one or a combination of polymers within the Polyaryletherketone (PAEK) family such as Polyether ether ketone (PEEK) or Polyetherketoneketone (PEKK). Further, materials such as Polyetherimide (PEI) or Polymide may be used.

The polymer may be carbon filled or loaded (e.g., with graphite nanotubes) to provide desired electrostatic discharge (ESD) dissipative properties (e.g., bleed off electrical charges). While carbon loading is one approach, in other embodiments, non-ESD material with electrically conductive finishes may be used to serve the same purpose. In another embodiment, the polymer may be silver loaded.

In an embodiment, the polymer may be a non-ESD material with a electrically conductive finish applied thereto.

The self-supporting body 104 includes an external or outward-facing surface 114 and an internal or inner-facing surface 116. In the embodiment of Figure 1, when the self-supporting space environment protection device 100 is installed, the external surface 114 faces the external environment (e.g., deep space, spaceexposed) and the internal surface 116 faces the component 102 (non-space exposed).

The internal surface 116 may be bare (i.e., the bare self-supporting polymer material) or may have a low-emissivity finish applied thereto. The low emissivity finish may help reduce heat losses.

The low emissivity finish may be a low-emissivity metallic plating applied thereto. The metallic plating may be an electroless nickel plating. The metallic plating may be a gold plating. The plating may be a silver plating. Preferably, the plating is a plating that is not sensitive to oxidation (would impact the emissivity). In an embodiment, the metallic plating may include multiple layers plated using a multilayer plating process. For example, the multilayer metallic plating may include a layer of nickel and a layer of gold on the nickel. In another example, the multilayer metallic plating may include a layer of nickel and a layer of silver on the nickel. In an embodiment using a multilayer metallic plating, the final layer may be silver, gold, or nickel.

In some cases, the internal surface 116 may be painted with a conductive paint prior to plating the internal surface with the low-emissivity metal. The conductive paint is a primer for plating the low emissivity finish. In other embodiments, other types of catalysts may be used for plating the low emissivity finish.

The low emissivity finish on the internal surface 116 helps keep heat inside (thermal insulation).

In an embodiment, the low emissivity finish is a low-emissivity paint.

In an embodiment, the low emissivity finish is lower than ε=0.7.

The external surface 114 may be bare (i.e., the bare self-supporting polymer material). The external surface 114 may include a low absorptivity finish applied thereto. The low absorptivity finish may be a white paint. The white paint may be applied by a spray gun. The low absorptivity finish reduce the heat gain from sun. In an embodiment, the low absorptivity finish may be white paint with α=<0.7

Whether a finish is applied to the internal or external surfaces 116, 114 may depend on the application and the type of component being protected or covered (e.g., highly dissipative unit, low dissipating unit).

In an embodiment the polymer is a bare black polymer-based material (ε∼0.9, α∼0.9) (and one, two, or none of internal surface 116 and external surface 114 is/are bare). In an embodiment, the low emissivity finish is a nickel plating (ε∼0.1, α∼0.4). In an embodiment, the low emissivity finish on the internal surface 116 is a gold plating (ε∼0.03, α∼0.2). In an embodiment, the low emissivity finish on the internal surface 116 is a silver plating. In an embodiment, the low emissivity finish on the internal surface 116 is a low emissivity paint. In an embodiment, the low absorptivity finish is a white paint (ε∼0.9, α∼0.17).

In an embodiment, the self-supporting space environment protection device 100 provides shielding for a highly dissipative unit exposed to the sun. White paint is applied to the external surface 114 and the internal surface 116 is bare to reject as much heat as possible.

In another embodiment, the self-supporting space environment protection device 100 provides insulation of a low dissipating unit. The external surface 114 is bare and a low emissivity finish is applied to the internal surface 116 to reduce heat losses.

The low emissivity material may provide temperature regulation to control the temperature level and heat inside the component 102. Low-emissivity metallic plating reduces radiative heat exchange, therefore maintaining the insulating capacity of the self-supporting space environment protection device 100. In an embodiment, the low emissivity finish is a finish with an IR (infrared) emissivity (ε) lower than the bare base material of the self-supporting space environment protection device 100. The bare base material includes the material used in the manufacture of the self-supporting space environment protection device 100. In an embodiment, the value of IR emissivity (ε) is preferred to be less than or equal to 0.7.

In an embodiment, the low absorptivity finish is a finish with a solar absorptivity (α) lower than the bare base material of the self-supporting space environment protection device 100. The bare base material includes the material used in the manufacture of the self-supporting space environment protection device 100. Alternatively, the bare base material includes the material profile of the external surface of the self-supporting space environment protection device 100.

In an embodiment, the value of solar absorptivity (α) is preferred to be less than or equal to 0.7.

In another embodiment, a plurality of self-supporting space environment protection devices 100 may be configured in a stackable arrangement to increase thermal insulation. For example, a first self-supporting space environment protection device 100 may be configured to cover the component and a second self-supporting space environment protection device 100 may be configured to cover, or stack on top of, the first self-supporting space environment protection device. In such an embodiment, the profiles of the respective first and second self-supporting space environment protection devices 100 may be adapted, as necessary to facilitate stacking (e.g., having similar or complementary surface profiles). While an example of two self-supporting space environment protection devices 100 in a stacked configuration is described, it is to be understood that stackable configurations including any number of self-supporting space environment protection devices 100 may be provided and are expressly contemplated by the present disclosure, provided such stack provides acceptable thermal protection properties and fits within size constraints for the application.

Advantageously, the composition of the self-supporting polymer-based device 100 in combination with either one or more of the internal and external finishing may provide temperature regulation, radiation shielding, atomic oxygen shielding, and MMOD (micro-meteoroid and orbital debris) protection.

In an embodiment, the low-absorptivity finish to the external surface and the low-emissivity finish to the internal surface are selected to provide temperature regulation.

In an embodiment, the rigid self-supporting polymer-based device 100 includes a silicone-based finish on the external surface. The silicone-based finish is configured to provide shielding from atomic oxygen resulting from the use of silicone.

In an embodiment the rigid self-supporting polymer-based device 100 does not have a surface finish or coating on the internal surface 116 or the external surface 114.

In an embodiment, the rigid self-supporting polymer-based device 100 has a surface finish or coating only on the external surface 114. The internal surface 116 may be left bare.

In an embodiment, the rigid self-supporting polymer-based device 100 has a surface finish or coating only on the internal surface 116. The external surface 114 may be left bare.

Table 1 below summarizes some possible configurations of the rigid self-supporting polymer-based device 100 in various embodiments, some of which have been described above. Embodiments include those directed to environmental protection (which may be combined with thermal management) and thermal management (which may be combined with environmental protection). Reference is made to components of Figure 1 (component 102, external and internal surfaces 114, 116). This includes what component 102 requires in terms of protection in the given embodiment/use case and how the external and internal surfaces 114, 116 are configured in the given embodiment/use case. In some cases, additional information on the embodiment or use case/context is provided (under "other"):

**TABLE 1**

| **102 requiring:** | **External (104)** | **Internal (106)** | **Other** |
|---|---|---|---|
| **Environmental protection (to combine with Thermal management)** | | | |
| **Sun protection** | Refer to thermal management | Refer to thermal management | Regardless of the finish and material thickness, adding a cover would fulfill this requirement. |
| **Atomic oxygen protection** | Silicone based finish | Refer to thermal management | |
| **Radiation protection** | Refer to thermal management | Refer to thermal management | Selection of polymer thickness |
| **MMOD protection** | Refer to thermal management | Refer to thermal management | Selection of polymer thickness or number of covers stackup. |

| **Thermal management (to combine with Environmental protection)** | | | |
|---|---|---|---|
| **Minimum insulation** | Bare* | Bare | |
| **Medium insulation** | Bare* | Low-emissivity | If cover is not space exposed, the side with low emissivity is not relevant. |
| **High insulation (Non-space exposed)** | Low-emissivity | Low-emissivity | One or more covers can be stacked to increase insulation |
| **High insulation (Space exposed)** | Top cover: Bare* | Top cover: Low-e | Two (or more) covers can be stacked to increase insulation |
| | Below cover: Low-e | Below cover: Low-e | |
| **Heat rejection and sun protection** | Low absorptivity* | Bare | |

| | | | |
|---|---|---|---|
| * unless otherwise specified by environmental protection | | | |

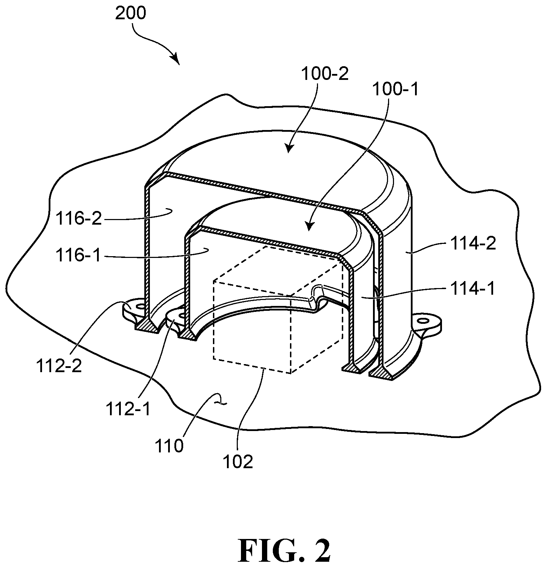

Referring now to Figure 2, shown therein is a stacked self-supporting space environment protection device 200 including two self-supporting space environment protection devices 100 of Figure 1, according to an embodiment.

Reference numerals for the two self-supporting space environment protection devices have been given the suffixes -1 and -2, respectively.

The stacked self-supporting space environment protection device 200 includes first and second self-supporting space environment protection devices 100-1 and 100-2, respectively. The first and second thermal protections devices 100-1, 100-2 are installed via respective mounting holes 112-1, 112-2. The first and second thermal protections devices 100-1, 100-2 include external surfaces 114-1, 114-2, and internal surfaces 116-1, 116-2, respectively. The component is mounted on a platform surface 110.

When installed, external surface 114-2 of the second self-supporting space environment protection device 100-2 is the only space-facing surface.

The internal surface 116-1 of the first self-supporting space environment protection device 100-1 has a low emissivity finish applied thereto. The external surface 114-1 of the first self-supporting space environment protection device 100-1 has a low emissivity finish applied thereto.

The internal surface 116-2 of the second self-supporting space environment protection device 100-2 has a low emissivity finish applied thereto. The external surface 114-2 of the second self-supporting space environment protection device 100-2 has a low absorptivity finish applied thereto.

The self-supporting space environment protection device has the advantage of being low cost and low mass and provides schedule/lead time improvements in development compared to the alternatives. This may be particularly true when additively manufactured.

Generally, the self-supporting space environment protection device of the present disclosure may duplicate the thermal and mechanical function of flexible blanket while providing significant advantages. Such advantages include, for example: repeatable thermal performance compared to complex-shaped blankets carrying multiple discontinuities, slits, or bends, tunable performance by using low emissivity finish and/or white paint.

Further, the device reduces manufacturing cost and assembly time; the device can be designed (e.g., in CAD) early in the program and ordered at the same time as other parts (and hence is not a critical schedule driver); the device provides improved robustness/reduced risk (flexible thermal blankets are easy to tear and can potentially jam the component); the device avoids the need for additional supports, and thus provides a lighter option; the device provides more predictable thermal efficiency (small flexible thermal blankets with multiple bends and slits are efficiency sensitive, and hence it is impossible to accurately predict the performance impact).

In an embodiment, compared to a thermal blanket which may require 150g of aluminum cage mass and 75g of blanket mass, an additively manufactured self-supporting space environment protection device 100 may require roughly 50% the mass of the aluminum cage only with a minimum print thickness of 0.05 inches.

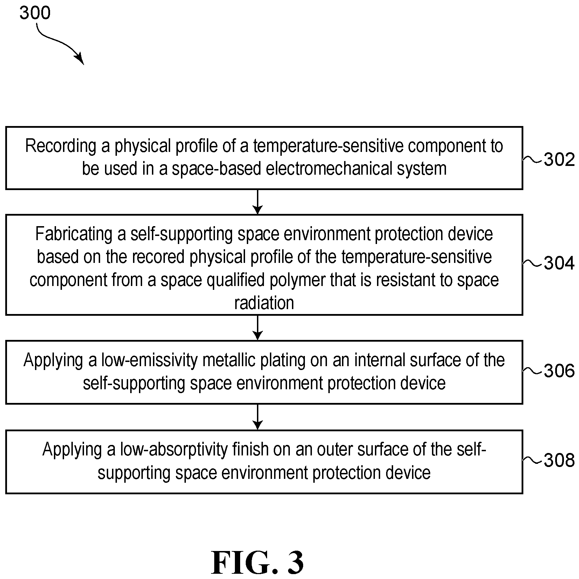

Referring now to Figure 3, shown therein is a method of manufacturing the self-supporting space environment protection device 100 of Figure 1, according to an embodiment.

At 302, the method 300 includes recording a physical profile of a temperature-sensitive component that is to be used in a space-based electromechanical system and that is to be protected or covered by the self-supporting space environment protection device.

Accurate measurements may be recorded of the component to create a digital representation of the component's shape and degrees of freedom in which the component operates.

The measurements may be recorded by 3D scanning, manual measurements, or photogrammetry.

In an embodiment, the shape of the self-supporting space environment protection device is determined based on the dimensions of the space-based instrument intended to be covered. In an embodiment, the self-supporting space environment protection device is designed in computer-aided design (CAD) software, or a similar system based on the physical profile (e.g., CAD) of the temperature-sensitive component being covered.

At 304, the method 300 includes fabricating a self-supporting space environment protection device based on the physical profile of the component recorded at 302 from a space qualified polymer that is resistant to space radiation. The self-supporting space environment protection device may be fabricated using a CAD model.

In an embodiment, the fabrication process includes employing an additive manufacturing technique.

In an embodiment, the self-supporting space environment protection device is manufactured using a molding process such as a machine mold or injection mold.

At 306, the method 300 includes applying a low-emissivity metallic plating on an internal surface (e.g., surface 116 of Figure 1) of the self-supporting space environment protection device.

At 308, the method 300 includes applying a low-absorptivity finish on an external surface (e.g., surface 114 of Figure 1) of the self-supporting space environment protection device.

While the above description provides examples of one or more apparatus, methods, or systems, it will be appreciated that other apparatus, methods, or systems may be within the scope of the claims as interpreted by one of skill in the art.

## Claims

1. A self-supporting space environment protection device for covering a component of a space-based system, the device comprising:
a self-supporting polymer-based body manufactured for installation on the component and composed of a space radiation resistant polymer-based material, the self-supporting polymer-based body comprising an internal surface that faces the component when the self-supporting space environment protection device is installed and an external surface exposed to the space environment.

2. The device of claim 1, wherein a low-absorptivity finish is applied to the external surface of the self-supporting polymer-based body, the low-absorptivity finish having a solar absorptivity (α) value lower than the space radiation resistant polymer-based material.

3. The device of claim 1, wherein a low-emissivity finish is applied to the internal surface of the self-supporting polymer-based body, the low-emissivity finish having an infrared emissivity (ε) value lower than the space radiation resistant polymer-based material.

4. The device of claim 1, wherein the space radiation resistant polymer-based material is either one of polymer composite, polyetherketoneketone (PEKK), PEKK-based FDM thermoplastic, or polyetherimide (PEl).

5. The device of claim 1, wherein the space radiation resistant polymer is carbon loaded to provide electrical conductivity and reduce ESD risk related to use of the self-supporting space environment protection device.

6. The device of claim 1, wherein the low-absorptivity finish is a white paint.

7. The device of claim 1, wherein the low-emissivity finish is a metallic plating.

8. The device of claim 7, wherein the metallic plating includes multiple plating layers, the multiple plating layers including a silver plating layer on a nickel plating layer or a gold plating layer on a nickel plating layer.

9. The device of claim 7, wherein the metallic plating includes multiple plating layers including a final metallic plating layer that is a nickel plating, a gold plating, or a silver plating.

10. The device of claim 1 wherein the low emissivity finish is a low-emissivity paint.

11. The device of claim 1, wherein the rigid polymer-based body is manufactured using either one of an additive manufacturing, a molding process, or a subtraction machining process.

12. The device of claim 1, wherein a low-absorptivity finish is applied to the external surface of the self-supporting polymer-based body and a low-emissivity finish applied to the internal surface of the self-supporting polymer-based body, the low-absorptivity finish having a solar absorptivity (α) value lower than the space radiation resistant polymer-based material and the low-emissivity finish having an infrared emissivity (ε) value lower than the space radiation resistant polymer-based material.

13. A method of manufacturing a self-supporting space environment protection device for covering a component used in space, the method comprising:
recording a physical profile of the space component;
fabricating a self-supporting polymer-based body based on the recorded physical profile of the temperature-sensitive device from a space radiation resistant polymer;
applying a low-absorptivity finish on an external surface of the self-supporting polymer-based body, the low-absorptivity finish having a solar absorptivity (α) value lower than the space radiation resistant polymer-based material; and
applying a low-emissivity finish on an internal surface of the self-supporting polymer-based body, the low-emissivity finish having an infrared emissivity (ε) value lower than the space radiation resistant polymer-based material.

14. The method of claim 13, wherein fabricating the rigid polymer body is performed using either one of an additive manufacturing, a molding process, or a subtraction machining process.

15. The method of claim 13, wherein:
the low-absorptivity finish is a white paint; and/or
the low emissivity finish is a metallic plating or a low-emissivity paint.
